# EUROPÄISCHE PATENTSCHRIFT

(11) **EP 3 320 615 B1**
(45) Veröffentlichungstag und Bekanntmachung des Hinweises auf die Patenterteilung: **23.12.2020**
(21) Anmeldenummer: 16736776.2
(22) Anmeldetag: 27.05.2016
(51) Int. Cl.: H02S 30/10

(54) **SOLARMODUL**
SOLAR MODULE
MODULE SOLAIRE

(30) Priorität: 06.07.2015 DE 102015110908
(43) Veröffentlichungstag der Anmeldung: 16.05.2018
(73) Patentinhaber: Hanwha Q CELLS GmbH, 06766 Bitterfeld-Wolfen (DE)
(72) Erfinder: WEGERT, Frank, 06808 Holzweissig (DE); SACHSE, Dirk, 04229 Leipzig (DE); BUSSE, Henning, 04105 Leipzig (DE)
(74) Vertreter: adares Patent- und Rechtsanwälte Reininger & Partner GmbB
(86) Internationale Anmeldenummer: PCT/DE2016/100245
(87) Internationale Veröffentlichungsnummer: WO 2017/005239

(56) Entgegenhaltungen:
- EP-A1- 1 860 705
- EP-A1- 2 187 450
- EP-A1- 2 267 792
- CN-A- 101 702 954
- DE-A1- 3 611 545
- DE-U1-202012 008 175
- US-A- 4 353 192

## Beschreibung

Die Erfindung betrifft ein Solarmodul, das ein Solarmodullaminat mit Solarmodullaminatkanten aufweist, wobei entlang mindestens einer der Solarmodullaminatkanten ein Rahmenprofil angeordnet ist. Das Rahmenprofil weist im Querschnitt betrachtet einen u-förmigen Aufnahmeabschnitt auf, der die Solarmodullaminatkante umschließt.

Das Solarmodullaminat ist üblicherweise als Glasscheibe ausgebildet, auf der als so genannte Strings elektrisch miteinander verschaltete Solarzellen angeordnet sind, die mit einer dauerhaft wetterbeständigen Kunststofffolie abgeklebt sind. Die Glasscheibe bildet die Frontseite des Solarmodullaminats aus, und die wetterbeständige Kunststofffolie bildet die Solarmodullaminat-Rückseite. Der u-förmige Aufnahmeabschnitt der Rahmenkonstruktion ist üblicherweise mittels zwei durch einen Verbindungsabschnitt verbundene und einander gegenüberliegende Schenkel gebildet. Diese werden abschnittsweise oder komplett mit Außenkanten dem Solarmodullaminat verklebt und/oder verklemmt, so dass die Rahmenkonstruktion das Solarmodullaminat als Rahmen entlang seiner Außenkanten umgibt. Dadurch wird die Stabilität und Verwindungssteifigkeit des Solarmodullaminats erhöht und/oder über die Rahmenkonstruktion eine Montagemöglichkeit geschaffen und/oder ein Kantenschutz für das Solarmodullaminat gewährleistet.

Der nicht zur Rahmenkonstruktion gehörige Laminat-Schichtaufbau von Glasscheibe, Solarzellenstrings, Einbettungspolymeren und wetterbeständiger Kunststofffolie wird im Rahmen dieser Erfindung daher als Solarmodullaminat bezeichnet. Die Kombination aus dem Solarmodullaminat mit der aus Rahmenprofilen gebildeten Rahmenkonstruktion wird als Solarmodul bezeichnet. Der Unterschied zwischen den Begriffen Solarmodul und Solarmodullaminat besteht darin, dass das Solarmodul im Vergleich zum Solarmodullaminat zusätzlich eine Rahmenkonstruktion und ggf. Klebemittel und/oder Klemmmittel zum Verkleben und Verklemmen der Rahmenkonstruktion mit dem Solarmodullaminat oder andere Befestigungsmittel aufweist. Wie in der DE 202012008175U1 beschrieben, können weiterhin mehrere Solarmodule samt Solarmodullaminaten und daran fixierten Rahmen in ein Einlegeprofil integriert werden, um das Einlegeprofil zu montieren, beispielsweise an einer Unterkonstruktion zu befestigen.

Der starke Wettbewerb zwischen den Herstellern von Solarmodulen zwingt diese insbesondere dazu, immer kostengünstigere Lösungen für die zum Einsatz kommenden Rahmenprofile zu entwickeln.

Regelmäßig kommen stranggepresste Rahmenprofile zum Einsatz, die um so günstigere Herstellungskosten bieten, je größer die produzierten Stückzahlen sind. Ein wesentlicher Kostenfaktor bei den stranggepressten Profilen ist die Herstellung der Strangpress-Matrizen. Dieses Umformverfahren bedingt zwangsläufig für das hergestellte Rahmenprofil Designfreiheitsgrade in nur zwei räumlichen Dimensionen.

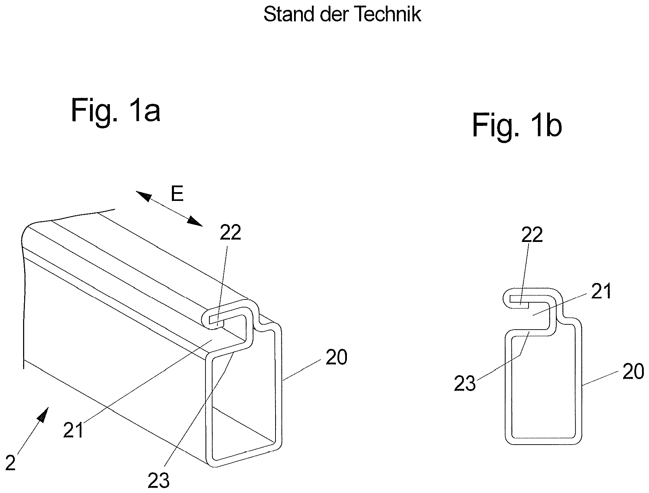

Ein gerade bei kleineren Stückzahlen deutlich kostengünstigeres Verfahren zur Herstellung metallischer Profile stellt das Umformen von Blechen durch Walzen, Formen und Rollen dar. Diese Herstellungsverfahren können auch als kostengünstige Inline-Verfahren durchgeführt werden. Vom Hersteller Welser Profile aus Ybbsitz, Österreich ist beispielsweise ein Rollprofil bekannt, das in den Figuren 1a und 1b gezeigt ist. Dieses gerollte Rahmenprofil ist entlang einer Erstreckungsrichtung (E) erstreckt und weist im Querschnitt eine Außenkante (20) und einen u-förmigen Aufnahmeabschnitt (21) mit einem oberen U-Schenkel (22) und einem unteren U-Schenkel (23) zur Aufnahme einer der Solarmodullaminatkanten auf. Dieses Rollprofil ist jedoch in seiner Herstellung vergleichsweise aufwändig und somit nicht kostengünstig genug.

EP 2 187 450 A1 beschreibt weiterhin ein Solarmodul mit einem Solarmodullaminat, das als Solarmodullaminatkanten zwei Seitenkanten, eine Oberkante und eine Unterkante aufweist. An den Kanten des Solarmodullaminats ist ein entlang einer Erstreckungsrichtung erstrecktes einstückiges Haupt-Rahmenprofil fixiert, das im Querschnitt eine Außenkante und einen u-förmigen Aufnahmeabschnitt mit einem oberen U-Schenkel und einem unteren U-Schenkel zur Aufnahme einer der Solarmodullaminatkanten aufweist. Dieses Haupt-Rahmenprofil wird mit einem Unter-Rahmenprofil verbunden, das eine angrenzende Kante des Solarmoduls hält und weiterhin eine Außenkante und einen u-förmigen Aufnahmeabschnitt mit einem oberen U-Schenkel und einem unteren U-Schenkel zur Aufnahme einer der Solarmodullaminatkanten und weiterhin eine Rahmen-Innenwand aufweist.

US 4 353 192 A beschreibt weiterhin einen Metallkörper für eine Gipswandbauplatte für eine verbesserte Feuerbeständigkeit in einer hohlen Schachtwandung. Der Metallkörper ist aus einem Metallprofil gebildet, bei dem mehrere Stücke in entgegengesetzte Richtungen herausgebogen sind. Die Stücke sind parallel zu einem Flansch, um die Gipswandbauplatte zu tragen.

Der vorliegenden Erfindung liegt die Aufgabe zu Grunde, ein Solarmodul mit einem Rahmenprofil bereit zu stellen, das bei günstigeren Herstellungskosten mindestens die gleiche oder eine größere Flexibilität hinsichtlich der Designfreiheitsgrade des Rahmenprofils bietet.

Diese Aufgabe wird durch ein Solarmodul mit den Merkmalen gemäß Anspruch 1 gelöst.

Erfindungsgemäß ist vorgesehen, dass das Rahmenprofil einstückig aus einem Metallband aufgebaut ist, das die Außenkante des Rahmenprofils mit einer Kantenebene bildet, wobei der obere U-Schenkel als Aufkantung des gesamten Metallbandes aus der Kantenebene heraus ausgebildet ist und der untere U-Schenkel als in Erstreckungsrichtung benachbart und voneinander beabstandet angeordnete Metallstützabschnitte ausgebildet ist, die als integrale Bestandteile des Metallbands aus der Kantenebene des Metallbands in Richtung des oberen U-Schenkels herausgebogen sind.

Durch diesen Aufbau des Rahmenprofils ist dessen Herstellung in Form eines äußerst günstigen in-line Verfahrens möglich, bei dem beispielsweise durch Rollen, Stanzen und Biegen die beanspruchte Struktur des Rahmenprofils geschaffen wird. Der untere U-Schenkel ist daher - anders als bei einem stranggepressten Rahmenprofil - in der Erstreckungsrichtung betrachtet nicht durchgehend ausgebildet. Er wird durch voneinander beabstandete Metallstützabschnitte gebildet, die jeweils aus dem Metallband herausgebogen sind.

Bevorzugt ist das Rahmenprofil strukturell ausschließlich gebildet aus dem in der Kantenebene verlaufenden Metallband und aus aus dieser Kantenebene herausgebogenen Abschnitten des Metallbands, wobei die herausgebogenen Abschnitte integrale Bestandteile des Metallbandes sind und beabstandet von der Kantenebene enden. Das Merkmal "strukturell ausschließlich ausgebildet" ist so definiert, dass der Grundaufbau des Rahmenprofils mit seinem das Solarmodullaminat tragenden u-förmigen Aufnahmeabschnitt aus dem flachen Metallband besteht. Diese Definition schließt jedoch nicht aus, dass zusätzliche strukturelle Elemente wie beispielsweise Einschraubnieten oder Metallwinkel am Rahmenprofil befestigt sind.

Besonders simpel im Aufbau zeichnet sich eine bevorzugte Ausführungsform des Solarmoduls dadurch aus, dass die herausgebogenen Abschnitte des Rahmenprofils ohne Einschluss von Hohlräumen enden. Das heißt im einfachsten Fall sind die herausgebogenen Abschnitte ausschließlich aus der Ebene des Metallbands herausgebogen und verlaufen geradlinig bis zu ihrem Endabschnitt. Bevorzugt sind die herausgebogenen Abschnitte ausschließlich einmal im Wesentlichen senkrecht aus der Ebene des Metallbands herausgebogen und verlaufen aus der Ebene des Metallbands bis zu ihrem Endabschnitt ohne weitere Änderungen ihrer Erstreckungsrichtung.

Bevorzugt sind die herausgebogenen Abschnitte ausschließlich als gefalzte obere und/oder untere Kanten des Metallbandes entlang der gesamten Erstreckungsrichtung des Metallbandes und als in Erstreckungsrichtung benachbart und voneinander beabstandet angeordnete Metallstützabschnitte ausgebildet. Dabei ist eine Vielzahl von Metallstützabschnitten vorgesehen, die beispielsweise nach einem vorangehenden abschnittsweisen Stanzen, Laser- oder Wasserstrahlschneiden des Metallbandes laschenartig aus dem Metallband herausgebogen sind.

Eine vorteilhafte Ausführungsform des Solarmodul ist dadurch gekennzeichnet, dass mindestens einer der Metallstützabschnitte in Erstreckungsrichtung betrachtet so lang ausgebildet ist, dass ein Eingriff mit einer Hand eines mit der Montage betrauten Monteurs möglich ist. Auf diese Weise lässt sich ohne zusätzliche Bauelemente eine Mehrzahl an Funktionalitäten des Solarmoduls mit dem Rahmenprofil realisieren.

In einer ersten Variante des Solarmodul ist vorgesehen, dass zwei Rahmenprofile an einer Ecke zweier Solarmodullaminatkanten mittels einer Steckverbindung aneinander fixiert sind, wobei das eine Rahmenprofil an seinem Ende eine Lasche aufweist, die in eine Laschenaufnahme des anderen Rahmenprofils eingesteckt ist. Auch die Lasche und die Laschenaufnahme lassen sich durch einfache und somit kostengünstige Stanz- und Biegeverfahren herstellen.

Eine zweite Variante des Solarmoduls ist dadurch gekennzeichnet, dass zwei Rahmenprofile an einer Ecke zweier Solarmodullaminatkanten mittels eines Eckwinkels aneinander fixiert sind oder jeweils in einen gemeinsamen Eckwinkel eingepresst sind. Dies stellt eine zweite Variante für die Eckverbindung zweier Rahmenprofile dar.

Bei einer dritten Variante des Solarmoduls sind zwei Rahmenprofile an einer Ecke zweier Solarmodullaminatkanten mittels einer Schweiß-, Löt-, Kleb- oder Schraubverbindung miteinander fixiert. Dies stellt eine kostengünstige Möglichkeit dar,

Jede der drei vorangehend genannten Varianten zur Eckverbindung zweier Rahmenprofile ist bevorzugt derart ausgebildet, dass sich das Rahmenprofil einstückig entlang der Oberkante oder entlang der Unterkante und entlang mindestens einer der beiden Seitenkanten des Solarmodullaminats erstreckt. Das heißt bei einem rechteckigen Solarmodullaminat sind entweder zwei aneinander stoßende Solarmodullaminatkanten oder drei der insgesamt vier Solarmodullaminatkanten mit einem einstückig ausgebildeten Rahmenprofil gerahmt. An den Ecken weist das Rahmenprofil derart dimensionierte Ausnehmungen auf, so dass ein Umbiegen des Rahmenprofils um im Wesentlichen 90 Grad ermöglicht ist. Auf diese Weise kann im Unterschied zu stranggepressten Rahmenprofilen die Anzahl an Arbeitsschritten zur Herstellung eines das Solarmodullaminat umlaufenden Rahmenprofils von vier auf zwei Eckverbindungsprozesse reduziert werden. Dadurch ist eine noch kostengünstigere Herstellung des gerahmten Solarmoduls möglich.

Jede der drei vorangehend genannten Varianten zur Eckverbindung lässt sich mit Vorteil derart ausbilden, dass sich das Rahmenprofil einstückig entlang der Oberkante, entlang der Unterkante und entlang beider Seitenkanten des Solarmodullaminats erstreckt. Das einstückige Rahmenprofil umschließt somit sämtliche Kanten des Solarmodullaminats und sein Anfangs- und Endabschnitt ist mittels einer Eckverbindung aneinander fixiert.

Weitere Eigenschaften und Vorteile der Erfindung werden im Zusammenhang mit den in den Figuren gezeigten und nachfolgend exemplarisch beschriebenen Ausführungsbeispielen verdeutlicht.

Es zeigen:
- Figur 1a und 1b: ein aus dem Stand der Technik bekanntes Hohlkammer-Rahmenprofil, das aus einem Metallblech umgeformt worden ist;
- Figur 2: eine Perspektivansicht eines Rahmenprofils 2 einer ersten Ausführungsform des Solarmoduls mit seiner nach innen zum Solarmodullaminat hin orientierten Rahmenprofil-Struktur;
- Figur 3: eine Perspektivansicht des Rahmenprofils 2 aus Figur 2 mit der nach außen vom Solarmodullaminat weg orientierten Rahmenprofil-Struktur;
- Figur 4: eine Perspektivansicht einer ersten Variante zur Eckverbindung zweiter Rahmenprofile 2,3;
- Figur 5: eine Perspektivansicht einer zweiten Variante zur Eckverbindung zweiter Rahmenprofile 2,3;
- Figur 6: eine Perspektivansicht einer dritten Variante zur Eckverbindung zweiter Rahmenprofile 2,3 und
- Figur 7: schematische Darstellungen besonders bevorzugter Ausgestaltungen des Solarmoduls mit einem Rahmenprofil 2, das sich einstückig entlang von zwei, drei oder vier Solarmodullaminatkanten erstreckt.

Figur 1a und 1b zeigen ein aus dem Stand der Technik bekanntes Hohlkammer-Rahmenprofil, das aus einem Metallblech umgeformt worden ist. Dieses Solarmodul-Rahmenprofil ist bereits in der Einleitung beschrieben worden. Auf diese Beschreibung wird hier verwiesen.

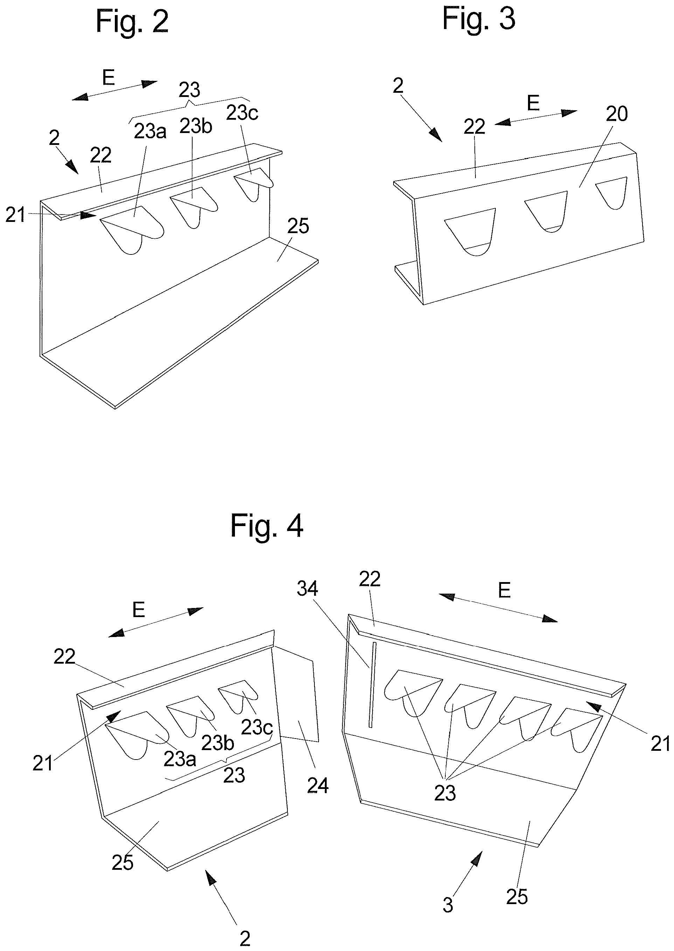

Figur 2 zeigt eine Perspektivansicht eines Rahmenprofils 2 einer ersten Ausführungsform des Solarmoduls mit seiner nach innen zum Solarmodullaminat hin orientierten Rahmenprofil-Struktur. Das Rahmenprofil 2 erstreckt sich entlang einer Erstreckungsrichtung E und ist aus einem einfachen Metallblech gebildet. Aus der Ebene des Metallblechs ist entlang der Erstreckungsrichtung E betrachtet die obere Kante des Metallblechs um im Wesentlichen 90 Grad abgekantet und bildet einen oberen U-Schenkel. Die untere Kante des Metallblechs ist ebenfalls entlang der Erstreckungsrichtung E im Wesentlichen parallel zum oberen U-Schenkel 22 abgekantet und bildet den unteren Schenkel 25. Zwischen oberem U-Schenkel 22 und dem unteren Schenkel 25 erstreckt sich das Metallblech des Rahmenprofils 2 in der Ebene des Metallblechs. Aus dieser Ebene sind entlang der Erstreckungsrichtung E benachbart zueinander aber voneinander beabstandet drei laschenartige Metallstützabschnitte 23a,23b,23c um im Wesentlichen 90 Grad im Wesentlichen parallel zum oberen U-Schenkel 22 aus der Ebene des Metallblechs herausgebogen. Diese drei Metallstützabschnitte 23a,23b,23c bilden mit weiteren, nicht gezeigten Metallstützabschnitten den unteren U-Schenkel 23 eines U-förmigen Aufnahmeabschnitts 21, der das hier der Übersichtlichkeit halber nur gestrichelt angedeutete Solarmodullaminat 1 mit einer seiner Solarmodullaminatkanten umgreift.

Figur 3 zeigt eine Perspektivansicht des Rahmenprofils 2 aus Figur 2 mit der nach außen vom Solarmodullaminat 1 weg orientierten Rahmenprofil-Struktur. Das durch die gleichmäßig beabstandete Anordnung der Metallstützabschnitte 23a,23b,23c bedingte regelmäßige Öffnungsbild der Rahmenprofil-Außenkante 20 fördert insbesondere die Hinterlüftung der Solarmodullaminatplatte. Außerdem können die Öffnungen auch abschnittsweise derart größer ausgebildet werden, dass ein mechanischer Eingriff für den Transport und die Montage des Solarmoduls gewährleistet ist.

Figur 4 zeigt eine Perspektivansicht einer ersten Variante zur Eckverbindung zweiter Rahmenprofile 2,3. Die beiden Rahmenprofile 2,3 sind entlang der Erstreckungsrichtung E ausgebildet wie in den Figuren 2 und 3 gezeigt.

Am Ende des einen Rahmenprofils 2 ist eine Lasche 24 ausgebildet, die sich vom oberen U-Schenkel 22 bis zum unteren Schenkel 25 erstreckt und aus der Ebene der Außenkante 20 herausgebogen ist. Korrespondieren zur Lasche 24 befindet sich im anderen Rahmenprofil 3 eine Laschenaufnahme 34 in Form eines Schlitzes, die sich vom oberen U-Schenkel 22 bis zum unteren Schenkel 25 erstreckt. Beim Zusammenfügen der beiden Rahmenprofile wird die Lasche 24 in die Laschenaufnahme 34 gesteckt und kann zusätzlich durch Befestigungsmittel wie beispielsweise Nieten, Schrauben oder Kleb- und Lötstoffe fixiert werden.

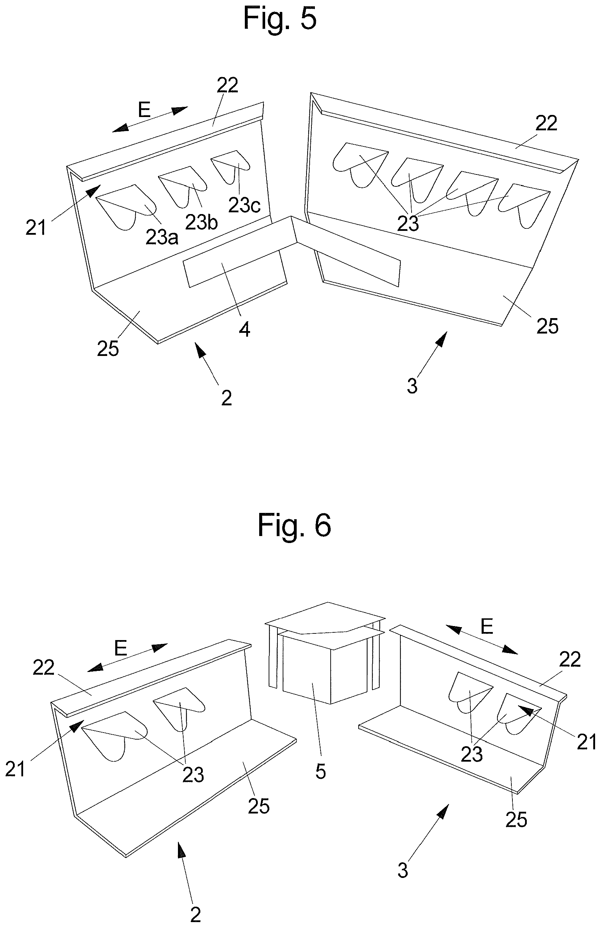

Figur 5 zeigt eine Perspektivansicht einer zweiten Variante zur Eckverbindung zweiter Rahmenprofile 2,3. Im Unterschied zu der in Figur 4 gezeigten ersten Variante ist hier ein zusätzliches Bauelement in Form eines Eckverbinders 4 vorgesehen. Der Eckverbinder 4 ist als Winkelblech mit zwei Schenkeln ausgebildet und wird mit jeweils einem seiner Schenkel an den zusammenzufügenden Rahmenprofilen 2,3 befestigt. Auch dazu eignen sich alle Arten form- und/oder kraftschlüssiger Verbindungsmittel.

Figur 6 zeigt eine Perspektivansicht einer dritten Variante zur Eckverbindung zweiter Rahmenprofile 2,3. Auch hier kommt wie bei der zweiten Variante in Figur 5 ein Eckverbinder 5 zum Einsatz. Allerdings ist dieser Eckverbinder 5 im Vergleich zu der Variante aus Figur 5 komplexer aufgebaut. Es handelt sich dabei um einen aus dem Stand der Technik bekannten Eckverbinder 5, der ein Einpressen der Endabschnitte der beiden Rahmenprofile 2,3 in den Eckverbinder 5 erlaubt.

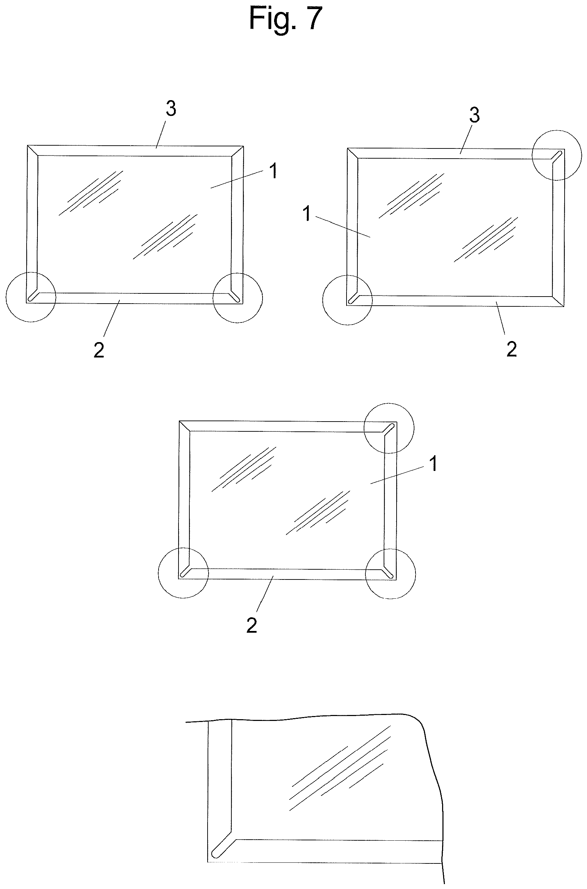

Figur 7 zeigt in schematischer Darstellung besonders bevorzugte Ausgestaltungen des Solarmoduls mit einem Rahmenprofil 2, das sich einstückig entlang von zwei, drei oder vier Solarmodullaminatkanten erstreckt. Die mit Kreisen hervorgehobenen Eckbereiche des Rahmenprofils 2 sind vergrößert dargestellt. In der vergrößerten Darstellung ist erkennbar, dass das Rahmenprofil 2 in diesen Eckbereichen einstückig ausgebildet ist. Der Winkel ist durch ein entsprechendes Verbiegen des Rahmenprofils 2 realisiert. Das Rahmenprofil 2 ist in diesen Eckbereichen am oberen U-Schenkel 22 und am unteren Schenkel 25 mit derartigen Ausnehmungen versehen, dass beim rechtwinkligen Verbiegen des Rahmenprofils 2 die entsprechenden Schenkel nicht ineinander verkanten.

### Bezugszeichenliste:

- 1: Solarmodullaminat
- 2: Rahmenprofil
20 Außenkante
21 u-förmiger Aufnahmeabschnitt
22 oberer U-Schenkel
23a, 23b, 23c Metallstützabschnitte
23 unterer U-Schenkel
24 Lasche
25 unterer Schenkel
- 3: Rahmenprofil
Laschenaufnahme
- 4: Eckwinkel
- 5: Eckwinkel

## Patentansprüche

1. Solarmodul mit einem Solarmodullaminat (1), das als Solarmodullaminatkanten zwei Seitenkanten, eine Oberkante und eine Unterkante aufweist, wobei an mindestens einer der Seitenkanten und/oder an der Oberkante und/oder an der Unterkante des Solarmodullaminats (1) ein entlang einer Erstreckungsrichtung (E) erstrecktes Rahmenprofil (2) fixiert ist, das im Querschnitt eine Außenkante (20) und einen u-förmigen Aufnahmeabschnitt (21) mit einem oberen U-Schenkel (22) und einem unteren U-Schenkel (23) zur Aufnahme einer der Solarmodullaminatkanten aufweist, wobei der obere U-Schenkel (22) und der untere U-Schenkel (23) des Rahmenprofils (2) abschnittsweise oder komplett mit Solarmodullaminatkanten des Solarmodullaminats (1) verklebt und/oder verklemmt sind,
**dadurch gekennzeichnet, dass**
das Rahmenprofil (2) einstückig aus einem Metallband aufgebaut ist, das die Außenkante (20) des Rahmenprofils mit einer Kantenebene bildet, wobei der obere U-Schenkel (22) als Aufkantung des gesamten Metallbandes aus der Kantenebene heraus ausgebildet ist und der untere U-Schenkel (23) als in Erstreckungsrichtung (E) benachbart und voneinander beabstandet angeordnete Metallstützabschnitte (23a, 23b, 23c) ausgebildet ist, die als integrale Bestandteile des Metallbands aus der Kantenebene des Metallbands in Richtung des oberen U-Schenkels (22) herausgebogen sind.

2. Solarmodul gemäß Anspruch 1, **dadurch gekennzeichnet, dass** das Rahmenprofil (1) strukturell ausschließlich gebildet ist aus dem in der Kantenebene verlaufenden Metallband und aus aus dieser Kantenebene herausgebogenen Abschnitten des Metallbands, wobei die herausgebogenen Abschnitte integrale Bestandteile des Metallbandes sind und beabstandet von der Kantenebene enden.

3. Solarmodul gemäß Anspruch 2, **dadurch gekennzeichnet, dass** die herausgebogenen Abschnitte ohne Einschluss von Hohlräumen enden.

4. Solarmodul gemäß Anspruch 2 oder 3, **dadurch gekennzeichnet, dass** die herausgebogenen Abschnitte ausschließlich als gefalzte obere und/oder untere Kanten des Metallbandes entlang der gesamten Erstreckungsrichtung (E) des Metallbandes und als in Erstreckungsrichtung (E) benachbart und voneinander beabstandet angeordnete Metallstützabschnitte (23a,23b,23c) ausgebildet sind.

5. Solarmodul gemäß einem der Ansprüche 1 bis 4, **dadurch gekennzeichnet, dass** mindestens einer der Metallstützabschnitte (23a,23b,23c) in Erstreckungsrichtung (E) betrachtet so lang ausgebildet ist, dass ein Eingriff mit einer Hand eines mit der Montage betrauten Monteurs möglich ist.

6. Solarmodul gemäß einem der vorangehenden Ansprüche, **dadurch gekennzeichnet, dass** zwei Rahmenprofile (2,3) an einer Ecke zweier Solarmodullaminatkanten mittels einer Steckverbindung aneinander fixiert sind, wobei das eine Rahmenprofil (2) an seinem Ende eine Lasche (24) aufweist, die in eine Laschenaufnahme (34) des anderen Rahmenprofils (3) eingesteckt ist.

7. Solarmodul gemäß einem der Ansprüche 1 bis 5, **dadurch gekennzeichnet, dass** zwei Rahmenprofile (2,3) an einer Ecke zweier Solarmodullaminatkanten mittels eines Eckwinkels (4) aneinander fixiert sind oder jeweils in einen gemeinsamen Eckwinkel (5) eingepresst sind.

8. Solarmodul gemäß einem der Ansprüche 1 bis 5, **dadurch gekennzeichnet, dass** zwei Rahmenprofile (2,3) an einer Ecke zweier Solarmodullaminatkanten mittels einer Schweiß-, Löt-, Kleb- oder Schraubverbindung miteinander fixiert sind.

9. Solarmodul gemäß einem der vorangehenden Ansprüche, **dadurch gekennzeichnet, dass** sich das Rahmenprofil (2) einstückig entlang der Oberkante oder entlang der Unterkante und entlang mindestens einer der beiden Seitenkanten des Solarmodullaminats erstreckt.

10. Solarmodul gemäß einem der Ansprüche 1 bis 8, **dadurch gekennzeichnet, dass** sich das Rahmenprofil (2) einstückig entlang der Oberkante, entlang der Unterkante und entlang beider Seitenkanten des Solarmodullaminats erstreckt

## Claims

1. A solar module having a solar module laminate (1) which has two side edges, a top edge and a bottom edge as solar module laminate edges, wherein a frame profile (2) that extends in an extension direction (E) is fixed to at least one of the side edges and/or to the top edge and/or to the bottom edge of the solar module laminate (1), said frame profile (2) having, in cross section, an outer edge (20) and a U-shaped receiving portion (21) with an upper U-shaped limb (22) and a lower U-shaped limb (23) for receiving one of the solar module laminate edges, wherein the upper U-shaped limb (22) and the lower U-shaped limb (23) of the frame profile (2) are glued and/or jammed in sections or completely with the solar module laminate edges of the solar module laminate (1),
**characterized in that**
the frame profile (2) is constructed integrally from a metal strip which forms the outer edge (20) of the frame profile with an edge plane, wherein the upper U-shaped limb (22) is formed as a folded edge of the entire metal strip out of the edge plane and the lower U-shaped limb (23) is configured as metal supporting portions (23a, 23b, 23c) that are arranged alongside one another in the extension direction (E) and in a manner spaced apart from one another, said metal supporting portions (23a, 23b, 23c) being bent out of the edge plane of the metal strip towards the upper U-shaped limb (22) as integral parts of the metal strip.

2. The solar module as claimed in claim 1, **characterized in that** the frame profile (1) is formed structurally only from the metal strip extending in the edge plane and from portions of the metal strip that are bent out of this edge plane, wherein the bent-out portions are integral parts of the metal strip and end at a distance from the edge plane.

3. The solar module as claimed in claim 2, **characterized in that** the bent-out portions end without inclusion of cavities.

4. The solar module as claimed in claim 2 or 3, **characterized in that** the bent-out portions are formed only as folded upper and/or lower edges of the metal strip along the entire extension direction (E) of the metal strip and as metal supporting portions (23a, 23b, 23c) that are arranged alongside one another in the extension direction (E) and in a manner spaced apart from one another.

5. The solar module as claimed in one of claims 1 to 4, **characterized in that** at least one of the metal supporting portions (23a, 23b, 23c) is configured to be long enough, as seen in the extension direction (E), for it to be possible for an installer tasked with installation to fit a hand therein.

6. The solar module as claimed in one of the preceding claims, **characterized in that** two frame profiles (2, 3) are fixed together at a corner of two solar module laminate edges by means of a plug connection, wherein one frame profile (2) has, at its end, a tab (24) which is plugged into a tab receptacle (34) in the other frame profile (3).

7. The solar module as claimed in one of claims 1 to 5, **characterized in that** two frame profiles (2, 3) are fixed together at a corner of two solar module laminate edges by means of a corner angle (4) or are each pressed into a common corner angle (5).

8. The solar module as claimed in one of claims 1 to 5, **characterized in that** two frame profiles (2, 3) are fixed together at a corner of two solar module laminate edges by means of a weld, soldered joint, adhesive bond or screw connection.

9. The solar module as claimed in one of the preceding claims, **characterized in that** the frame profile (2) extends integrally along the top edge or along the bottom edge and along at least one of the two side edges of the solar module laminate.

10. The solar module as claimed in one of claims 1 to 8, **characterized in that** the frame profile (2) extends integrally along the top edge, along the bottom edge and along the two side edges of the solar module laminate.

## Revendications

1. Un module solaire ayant un laminé de module solaire (1) qui a deux bords latéraux, un bord supérieur et un bord inférieur comme des bords du laminé de module solaire, dans lequel à au moins l'un des bords latéraux et / ou au bord supérieur et / ou au bord inférieur du laminé de module solaire (1) un profilé de cadre (2) s'étendant le long d'une direction d'extension (E) est fixé, qui en section transversale a un bord extérieur (20) et une section de réception en forme d'U (21) ayant une branche d'U supérieure (22) et une branche d'U inférieure (23) pour recevoir l'un des bords du laminé de module solaire, dans lequel la branche d'U supérieure (22) et la branche d'U inférieure (23) du profilé de cadre (2) sont collées et/ou coincées partiellement ou complètement avec les bords du laminé de module solaire du laminé de module solaire (1),
**caractérisé en ce que**
le profilé de cadre (2) est réalisé d'une seule pièce à partir d'une bande métallique qui forme le bord extérieur (20) du profilé de cadre avec un plan de bord, dans lequel la branche d'U supérieure (22) est formée comme un montant de la bande métallique entière à partir du plan de bord et la branche d'U inférieure (23) est formée comme des sections de support métalliques (23a, 23b, 23c) disposées adjacentes et espacées l'une de l'autre dans la direction d'extension (E), qui sont pliées hors du plan de bord de la bande métallique dans la direction de la branche d'U supérieuere (22) comme composants intégraux de la bande métallique.

2. Un module solaire selon la revendication 1, **caractérisé en ce que** le profilé de cadre (1) est structurellement formé exclusivement à partir de la bande métallique s'étendant dans le plan de bord et de sections de la bande métallique pliées hors de ce plan de bord, dans lequel les sections pliées sont des composants intégraux de la bande métallique et se terminent à distance du plan de bord.

3. Un module solaire selon la revendication 2, **caractérisé en ce que** les sections pliées se terminent sans l'inclusion de cavités.

4. Un module solaire selon la revendication 2 ou 3, **caractérisé en ce que** les sections pliées sont exclusivement formées comme des bords repliés supérieurs et / ou inférieurs de la bande métallique sur toute la direction d'extension (E) de la bande métallique et comme des sections de support métalliques (23a, 23b, 23c) adjacentes et espacées l'une de l'autre dans la direction d'extension (E).

5. Un module solaire selon l'une des revendications 1 à 4, **caractérisé en ce qu'**au moins une des sections de support métalliques (23a, 23b, 23c), vues dans la direction de l'extension (E), est si longue qu'il est possible à un installateur chargé de l'assemblage d'intervenir d'une main.

6. Un module solaire selon l'une des revendications précédentes, **caractérisé en ce que** deux profilés de cadre (2, 3) sont fixés l'un à l'autre à un coin de deux bords du laminé de module solaire au moyen d'une connexion enfichable, le profilé de cadre (2) ayant une patte (24) à son extrémité qui est insérée dans un logement de patte (34) de l'autre profilé de cadre (3).

7. Un module solaire selon l'une des revendications 1 à 5, **caractérisé en ce que** deux profilés de cadre (2, 3) sont fixés l'un à l'autre à un coin de deux bords du laminé de module solaire au moyen d'une cornière d'angle (4) ou sont chacun pressés dans une cornière d'angle commune (5).

8. Un module solaire selon l'une des revendications 1 à 5, **caractérisé en ce que** deux profilés de cadre (2, 3) sont fixés l'un à l'autre au coin de deux bords du laminé de module solaire au moyen d'un assemblage par soudure, brasage, adhésif ou vissage.

9. Un module solaire selon l'une des revendications précédentes, **caractérisé en ce que** le profilé de cadre (2) s'étend d'une seule pièce le long du bord supérieur ou le long du bord inférieur et le long d'au moins l'un des deux bords latéraux du laminé de module solaire.

10. Un module solaire selon l'une des revendications 1 à 8, **caractérisé en ce que** le profilé de cadre (2) s'étend d'une seule pièce le long du bord supérieur, le long du bord inférieur et le long des deux bords latéraux du laminé de module solaire.
